# EUROPEAN PATENT SPECIFICATION

(11) **EP 0 775 931 B1**
(45) Date of publication and mention of the grant of the patent: **05.10.2005**
(21) Application number: 96308344.9
(22) Date of filing: 19.11.1996
(51) Int. Cl.: G02F 1/136

(54) **Method of manufacturing a liquid crystal display**
Verfahren zur Herstellung einer Flüssigkristall-Anzeige
Procédé de fabrication d'un afficheur à cristaux liquides

(30) Priority: 21.11.1995 KR 9542618; 30.04.1996 KR 9613912
(43) Date of publication of application: 28.05.1997
(60) Divisional application: 03076155.5
(73) Proprietor: SAMSUNG ELECTRONICS CO., LTD., Kyungki-do (KR)
(72) Inventor: Lee, Jueng-gil, Bundang-gu, Seongnam-city, Kyungki-do (KR); Lee, Jung-ho, Suwon-city, Kyungki-do (KR); Nam, Hyo-rak, Icheon-eub, Icheon-gun, Kyungki-do (KR)
(74) Representative: Ertl, Nicholas Justin

(56) References cited:
- EP-A- 0 312 389
- US-A- 5 374 837
- US-A- 5 397 719
- PATENT ABSTRACTS OF JAPAN vol. 11, no. 19 (P-537) & JP 61 193128 A (MITSUBISHI)
- PATENT ABSTRACTS OF JAPAN vol. 18, no. 194 (P-1722) & JP 06 003698 A (NEC)
- PATENT ABSTRACTS OF JAPAN vol. 18, no. 481 (P-1797) & JP 06 160905 A (SANYO)

## Description

The present invention relates to a method for manufacturing a liquid crystal display. In particular aspects, it relates to an improved method for manufacturing a thin film transistor-liquid crystal display in which the number of photolithography processes to be performed is reduced.

A thin film transistor LCD (referred to hereinafter as TFT-LCD) which uses a thin film transistor as the active device has various advantages such as low power consumption, low voltage drive, thinness, and light weight, for example.

Since a thin film transistor (TFT) is significantly thinner than a conventional transistor, the process of manufacturing one is complicated, so productivity is low and manufacturing costs are high. In particular, since a mask is used in every manufacturing step, at least seven masks are required. Various methods for increasing productivity in manufacturing the TFT and in lowering the manufacturing costs have been studied. In particular, a method for reducing the number of the masks used during the manufacturing process has been widely researched.

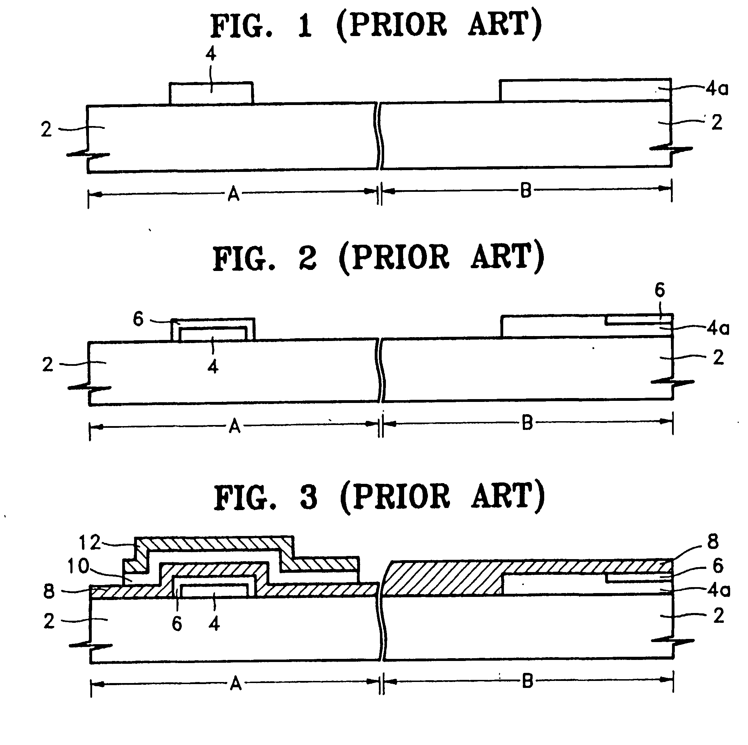

FIGS. 1 to 4 are sectional views for explaining the method for manufacturing an LCD according to a conventional technology as disclosed in U.S. Patent No. 5,054,887.

In the drawings, reference characters **A** and **B** denote a TFT area and a pad area, respectively. Referring to FIG. 1, after forming a first metal film by depositing pure A1 on a transparent substrate 2, gate patterns 4 and 4a are formed by performing a first photolithography step on the first metal film. The gate patterns are used as a gate electrode 4 in the TFT area and as a gate pad 4a in the pad area.

Referring to FIG. 2, after forming a photoresist pattern (not shown) which covers a portion of the pad area by performing a general photolithography step, an anodized film 6 is formed by oxidizing the first metal film using the photoresist pattern as an anti-oxidation film. At this time, the anodized film 6 is formed on the entire surface of the gate electrode 4 formed in the TFT area and on a portion of the gate pad 4a in the pad area.

Referring to FIG. 3, an insulating film 8 is formed by depositing, for example, a nitride film on the entire surface of the substrate 2 having the anodized film thereon. Then, after forming a semiconductor film by subsequently depositing an amorphous silicon film 10 and an amorphous silicon film 12 doped with impurities on the entire surface of the substrate 2 on which the insulating film 8 is formed, a semiconductor film pattern 10 and 12 to be used as an active portion is formed in the TFT area by performing a third photolithography step on the semiconductor film.

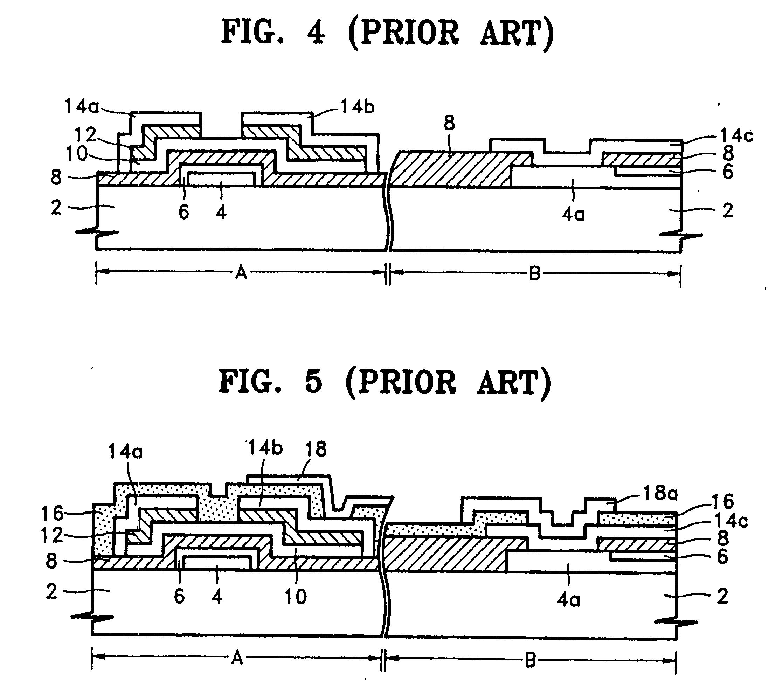

Referring to FIG. 4, a photoresist pattern (not shown) is formed which exposes a portion of the gate pad 4a formed in the pad area by performing a fourth photolithography step on the entire surface of the substrate 2 on which the semiconductor film pattern is formed. A contact hole which exposes a portion of the gate pad 4a is then formed by etching the insulating film 8 using the photoresist pattern as a mask. Then, a source electrode 14a and a drain electrode 14b are formed in the TFT area by depositing a Cr film on the entire surface of the substrate having the contact hole thereon and performing a fifth photolithography step on the Cr film. In the pad area, a pad electrode 14c connected to the gate pad 4a through the contact hole is formed. At this time, the impurity doped-amorphous silicon film 12 on the upper portion of the gate electrode 4 formed in the TFT area during the photolithography process is partially etched, thus exposing a portion of the amorphous silicon film 10.

Referring to FIG. 5, a protection film 16 is formed by depositing an oxide film on the entire surface of the substrate 2 on which the source electrode 14a, the drain electrode 14b and the pad electrode 14c are formed. Then, contact hole which exposes a portion of the drain electrode 14b of the TFT area and which expose a portion of the pad electrode 14c of the pad area are formed by performing a sixth photolithography step on the protection film.

Subsequently, pixel electrodes 18 and 18a are formed by depositing indium tin oxide ITO, which is a transparent conductive material, on the entire surface of the substrate having the contact holes and performing a seventh photolithography step on the ITO film. As a result, the drain electrode 14b and the pixel electrode 18 are connected in the TFT area and the pad electrode 14c and the pixel electrode 18a are connected in the pad area.

According to the conventional method for manufacturing the LCD, pure A1 is used as the gate electrode material for lowering the resistance of a gate line. Therefore, an anodizing process is required to prevent a hillock caused by the Al, thus complicating the manufacturing process, reducing productivity, and increasing manufacturing costs.

JP 61-193128 discloses a matrix type display device having a bottom gate formed of aluminium with a chromium layer on top. A gate insulator layer, a semiconductor layer and a pixel electrode are formed.

EP 312389 discloses a liquid crystal panel in which an indium tin oxide (ITO) film may be formed on the terminal electrodes as well as forming the picture elements.

JP 06-160905 discloses a liquid crystal display device in which deterioration by electrolytic corrosion of ITO and Al is prevented. Processing is simplified by covering the gate lines with gate insulating films and providing gate terminals consisting of ITO via the contact of the gate insulating films.

According to the invention there is provided a method of manufacturing a liquid crystal display as set out in claim 1.

It is an object of the present invention to provide an improved method of manufacturing a liquid crystal display in which manufacturing costs are reduced and productivity increased by reducing the number of photolithography processes performed.

It is another object of the present invention to provide a method of manufacturing a liquid crystal display by which it is possible to prevent deterioration of device characteristics by preventing generation of an undercut in a gate electrode.

In one aspect of the invention, there is provided an improved method of manufacturing a liquid crystal display according to the present invention, comprising the steps of forming a gate electrode and a gate pad by sequentially depositing a first metal film and a second metal film on a substrate of a TFT area and a pad area, respectively, by a first photolithography process, forming an insulating film on the entire surface of the substrate on which the gate electrode and the gate pad are formed, forming a semiconductor film pattern on the insulating film of the TFT are using a second photolithography process, forming a source electrode and a drain electrode composed of a third metal film in the TFT area using a third photolithography process, forming a protection film pattern which exposes a portion of the drain electrode and a portion of the gate pad on the substrate on which the source electrode and the drain electrode are formed using a fourth photolithography process, and forming a pixel electrode connected to the drain electrode and the gate pad on the substrate on which the protection film pattern is formed using a fifth photolithography process.

The first metal film is preferably formed of Al or Al alloy and the second metal film is preferably formed of one metal selected from the group consisting of Cr, Ta, Mo, and Ti.

The step of forming the gate electrode includes the steps of forming the first metal film and the second metal film on a substrate in the described order, forming a photoresist pattern on a portion of the second metal film, etching the second metal film using the photoresist pattern as a mask, reflowing the photoresist pattern, etching the first metal film using the reflowed photoresist pattern as a mask, and removing the reflowed photoresist pattern. At this time, the second metal film is overetched in the step of etching the second metal film to generate an undercut. The step of reflowing the photoresist pattern are performed in multiple steps.

The step of forming the gate electrode preferably includes the steps of forming the first metal film and the second metal film on the substrate in the described order, forming a photoresist pattern on a portion of the second metal film, etching the second metal film by dry etching using the photoresist pattern as a mask, and etching the first metal film. At this time, the second metal film is preferably wet or dry etched and the step of baking the photoresist pattern is preferably further comprised after the step of etching the second metal film.

The step of forming the gate electrode preferably includes the steps of forming the first metal film and the second metal film on a substrate, forming a photoresist pattern on a portion of the second metal film, etching the second metal film using the photoresist pattern as a mask, etching the first metal film using the patterned second metal film, and re-etching the patterned second metal film. At this time, the step of baking the photoresist pattern is preferably further comprised prior to the step of etching the first metal film after etching the second metal film.

According to aspects of the present invention, it is possible to prevent a battery effect and a hillock caused by directly contact of Al to the ITO by forming the gate electrode in a double structure of Al or an Al alloy and a refractory metal film. Also, it is possible to omit the anodizing process and to simultaneously etch the insulating layer and the protection film due to a capping film, thus reducing the number of the photolithography processes. Also, since it is possible to form the first metal film larger than or identical to the second metal film, an undercut is not generated in the gate electrode. Therefore, it is possible to prevent the deterioration of insulation characteristics due to poor step coverage during deposition of the insulating film after forming the gate electrode.

Specific embodiments of the present invention are described in detail below, by way of example, with reference to the attached drawings, in which:
FIGS. 1 through 5 are sectional views for explaining a method of manufacturing liquid crystal display according to a conventional method;
FIG. 6 is a schematic plan view of the mask patterns used for manufacturing a liquid crystal display according to embodiments of the present invention;
FIGS. 7 through 11 are sectional views for explaining a method of manufacturing a liquid crystal display according to a first embodiment of the present invention;
FIG. 12 is a sectional view showing generation of an undercut in a gate electrode;
FIGS. 13 through 16 are sectional views for explaining a method of manufacturing a liquid crystal display according to a second embodiment of the present invention;
FIGS. 17 through 19 are sectional views for explaining a method of manufacturing a liquid crystal display according to a third embodiment of the present invention; and
FIGS. 20 through 23 are sectional views for explaining a method of manufacturing a liquid crystal display according to a fourth embodiment of the present invention.

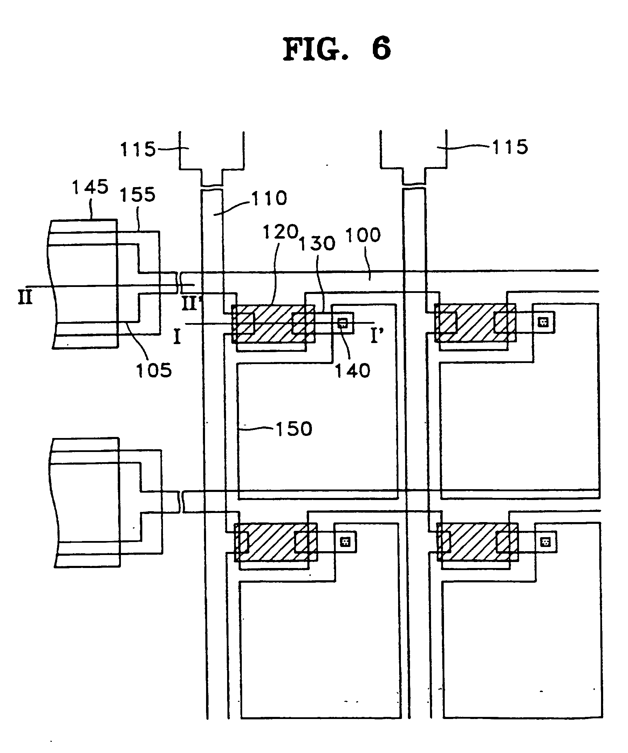

FIG. 6 is a schematic plan view of the mask patterns used for manufacturing a liquid crystal display according to embodiments of the present invention, in which reference numeral 100 denotes a mask pattern for forming a gateline, reference numeral 105 denotes a mask pattern for forming a gate pad, reference numeral 110 denotes a mask pattern for forming a data line, reference numeral 120 denotes a mask pattern for forming a semiconductor film, reference numeral 130 denotes a mask pattern for forming a source electrode/drain electrode, reference numeral 140 denotes a mask pattern for forming a contact hole for connecting a pixel electrode to the drain electrode in the TFT area, reference numeral 145 denotes a mask pattern for forming a contact hole for connecting a gate pad in the pad area to the pixel electrode, reference numeral 150 denotes a mask pattern for forming a pixel electrode in the TFT area, and reference numeral 155 denotes a mask pattern for forming a pixel electrode in the pad portion.

Referring to FIG. 6, the gate line 100 is horizontally arranged, the data line 110 is arranged in a matrix pattern perpendicular to the gate line, the gate pad 105 is provided at the end portion of the gate line 100, and the data pad 115 is provided at the end portion of the data line. Pixel portions are respectively arranged in the matrix pattern in the portion bounded by the two adjacent gate lines and the data line. The gate electrodes of the respective TFTs are formed so as to protrude to the pixel portions from the respective gate lines. The semiconductor film 120 is formed between the drain electrodes of the respective TFTs and the gate electrodes of the respective TFTs. The source electrodes of the TFTs are formed in protruding portions from the data line 110. The pixel electrodes 150 composed of the transparent ITO are formed in the respective pixel portions.

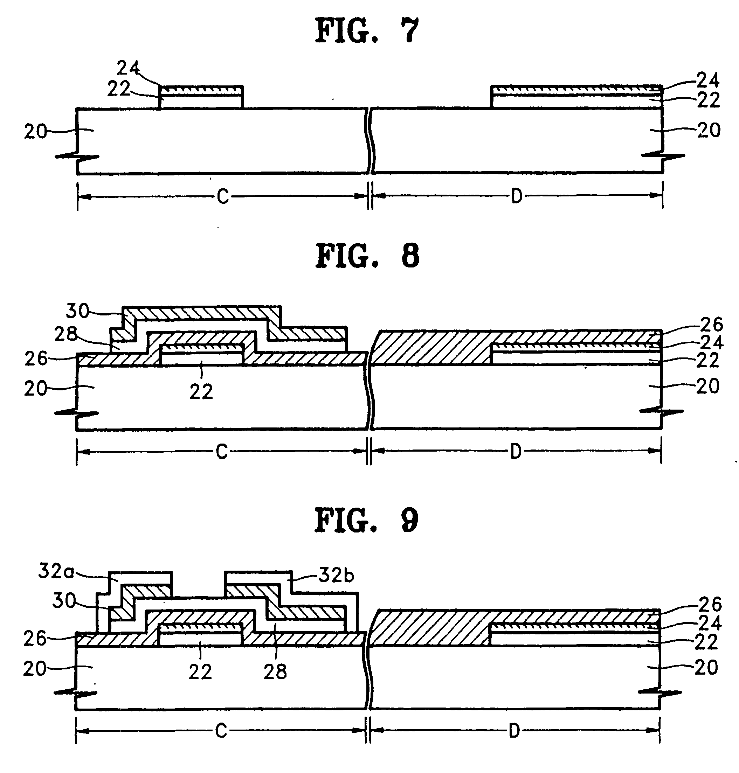

FIGS. 7 through 11 are sectional views for explaining a method of manufacturing a liquid crystal display according to a first embodiment of the present invention. Reference character C represents the TFT area, which is a sectional view taken along I-I' of FIG. 6 and reference character **D** represents the pad area, which is a sectional view taken along II-II' of FIG. 6.

FIG. 7 shows the steps of forming the gate electrode, in which a first metal film 22 is formed by depositing an Al or an Al alloy film to a thickness of 2,000-4,000Å on a transparent substrate 20. Then, a second metal film 24 is formed by depositing a refractory metal film to a thickness 500-2,000Å on the first metal film. Then, gate patterns are formed in the TFT area and the pad area by performing a first photolithography step on the first and the second metal films 22 and 24. The gate patterns are used as a gate electrode in the TFT area and used as a gate pad in the pad area. At this time, the first and the second metal films are wet or dry etched using a mask.

Here, the first metal film 22 is formed of Al or an Al alloy such as Al-Nd or Al-Ta. It is possible to lower the resistance of the gate line and to prevent generation of a hillock when the gate electrode is formed of such an Al alloy. The second metal film 24, which is a capping film to prevent the Al alloy from contacting the ITO film to be formed in a subsequent process, is formed of one refractory metal selected from the group consisting of Cr, Ta, Mo, and Ti. Due to the capping film on the Al or Al alloy, a high temperature oxidation process and a photolithography process for forming an oxidized film are not required. Also, since the second metal film 24 does not include Al, a battery effect generated in the conventional technology does not arise even though the second metal film 24 directly contacts the ITO film to be formed in a subsequent process.

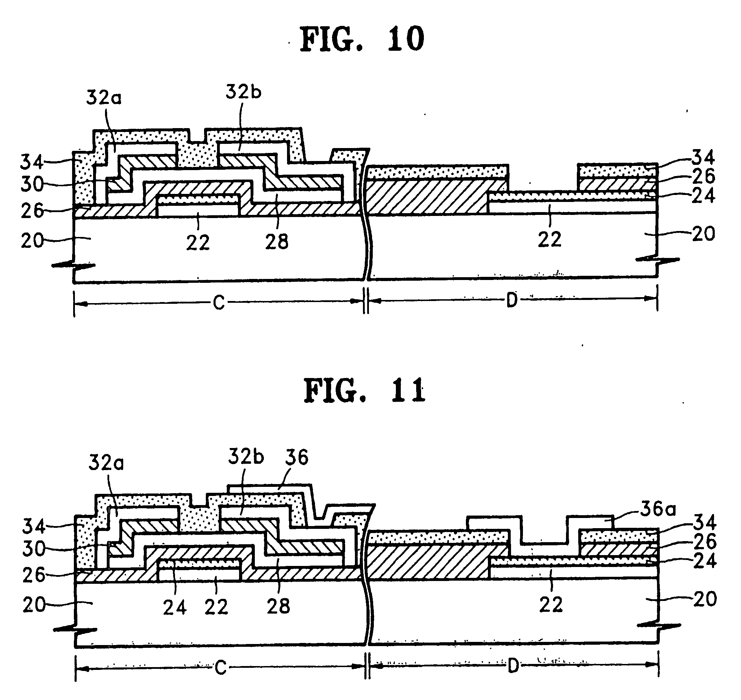

FIG. 8 shows the steps of forming a semiconductor film pattern, in which an insulating film 26 is formed by depositing a nitride film to a thickness of about 4,000Å on the entire surface of the substrate on which a gate pattern is formed. Subsequently, a semiconductor film composed of an amorphous silicon film 28 and an impurity doped-amorphous silicon film 30 is formed to a thickness of 1,000-2,000Å and a thickness of 500Å on the insulating layer 26. Then, the semiconductor film pattern to be used as an active area is formed in the TFT area by performing a second photolithography step on the semiconductor film.

FIG. 9 shows the steps of forming a source electrode and a drain electrode. A third metal film is formed by depositing a Cr film to a thickness of 1,000-2,000Å on the entire surface of the substrate 20 on which the semiconductor film pattern is formed by a sputtering method. A source electrode 32a and a drain electrode 32b are then formed in the TFT area by performing a third photolithography step on the third metal film.

FIG. 10 shows the steps of forming a protection film pattern. The protection film is formed by depositing an insulating material, e.g., an oxide film, to a thickness of 1,000-3,000Å on the entire surface of the substrate on which the source electrode 32a and the drain electrode 32b are formed. Then, a protection film pattern 34, which exposes a portion of the drain electrode 32b and a portion of the gate electrode 22 and 24 formed in the pad area, i.e., a gate pad, is formed by performing a fourth photolithography step on the protection film. In the pad area, the protection film 34 and the insulating film 26 which are formed on the gate pad are etched simultaneously.

FIG. 11 shows the steps of forming a pixel electrode. After forming the ITO film, which is a transparent conductive film, by a sputtering method on the entire surface of the substrate on which the protection film pattern is formed, pixel electrodes 36 and 36a are formed in the TFT area and the pad area by performing a fifth photolithography step on the ITO film. As a result, the pixel electrode 36 and the drain electrode 32b are connected in the TFT area and the pixel electrode 36a and the gate pad 22 and 24 are connected in the pad area.

According to the method of forming a liquid crystal display according to a first embodiment of the present invention, a battery effect and an Al hillock caused by contact of the Al to the ITO is prevented by forming a gate electrode using an Al or Al alloy and by forming a capping film on the gate electrode using a refractory metal. Also, it is possible to reduce the number of photolithography processes by omitting the anodizing process and simultaneously forming the contact on the insulating film and the protection film.

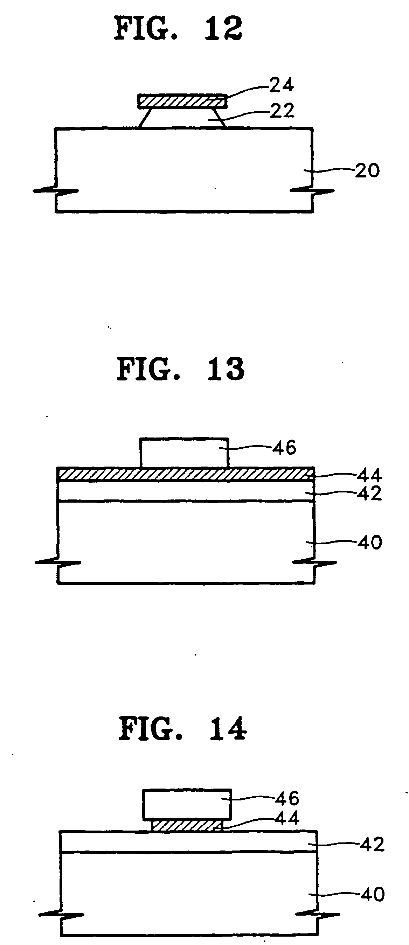

The first metal film 22 and the second metal film 24 which constitute the gate electrode in the first embodiment of the present invention are etched using only one mask. Therefore, an undercut may be generated in the gate electrode as shown in FIG. 12. As a result, step coverage becomes poor in a subsequent insulating film depositing process, thus creating a risk of deteriorating insulation characteristics. In the second through fourth embodiments of the present invention, a method for preventing the generation of the undercut in the gate electrode is provided.

FIGS. 13 through 16 are sectional views for explaining a method of manufacturing a liquid crystal display according to a second embodiment of the present invention. Here, the initial steps through the step of forming the gate electrode are shown.

FIG. 13 shows the step of forming the conductive films for the gate electrode. First, a first metal film 42 is formed by depositing an Al or Al alloy film to a thickness of 2,000~4,000Å on a transparent substrate 40. Then, a second metal film 44 to be used as a capping film is formed by depositing a refractory metal, such as Cr, Ta, Mo, or Ti, preferably Cr, on the first metal film 42. Here, Al-Nd or Al-Ta can be used as the Al alloy.

FIG. 14 shows the step of forming a photoresist pattern 46. A photoresist pattern 46 is formed by coating photoresist on the second metal film 44 and exposing and developing the photoresist. Then, a second metal film 44 is etched using the photoresist pattern 46 as a mask. At this time, an undercut is generated in the second metal film 44 by sufficiently overetching the second metal film.

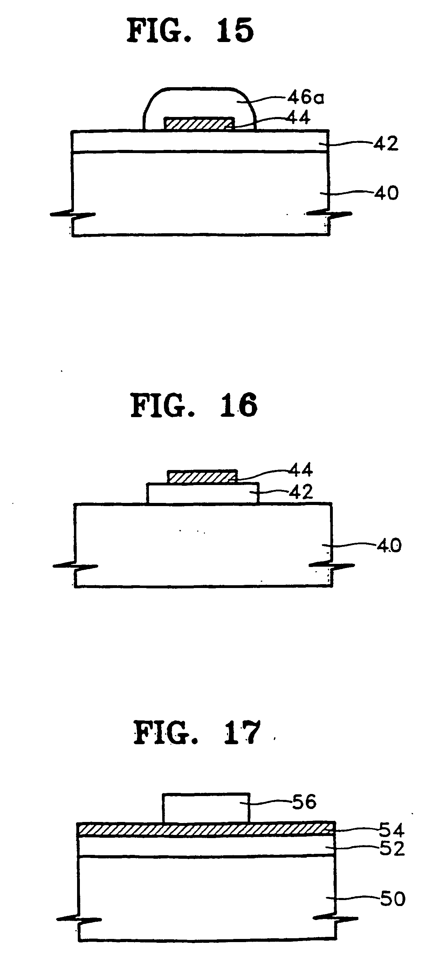

FIG. 15 shows the step of reflowing the photoresist. The substrate is heated to a temperature above 100°C to reflow the photoresist. At this time, a heat treatment may be performed on the substrate over multiple steps in order to improve the reflow characteristic of the photoresist. As a result, the patterned second metal film 44 is completely covered by the reflowed photoresist 46a.

FIG. 16 shows the steps of forming the gate electrode. A photoresist pattern is removed after etching the first metal film 42 using the reflowed photoresist pattern 46a of FIG. 15 as a mask. As a result, since the first metal film 42 is etched to be wider than the second metal film 44 by the thickness of the photoresist 46a of FIG. 15, the step coverage of the insulating film is favorably formed in a subsequent insulating film depositing process. At this time, to prevent the first metal film 42 from contacting the ITO layer to be formed in a subsequent process, it is preferable to control the thickness and the size of the photoresist pattern so as to form the patterned second metal film 44 to be larger than the contact hole for connecting the ITO layer and the gate pad.

The following steps are identical to those of the above-described first embodiment, so the explanation of those steps is omitted here and the reader is referred to the description of the first embodiment.

FIGS. 17 through 19 are sectional views for explaining a method of manufacturing a liquid crystal display according to a third embodiment of the present invention. Here, the initial steps through the step of forming the gate electrode are shown.

FIG. 17 shows the step of forming conductive films 52 and 54 for the gate electrode and a photoresist pattern 56, which is identical to the second embodiment in FIG. 13 of the present invention.

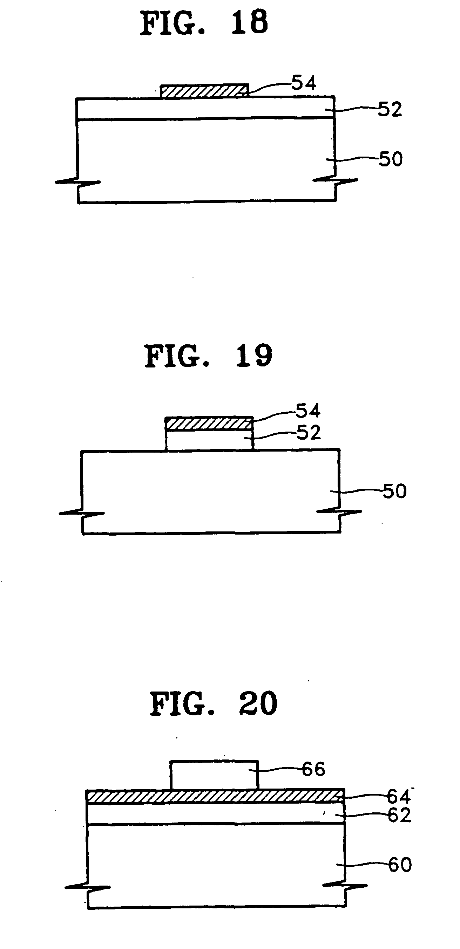

FIG. 18 shows the step of patterning the second metal film 54, in which the second metal film 54 is wet or dry etched using the photoresist pattern 56 of FIG. 17 as a mask. Then, the photoresist pattern is removed. The photoresist pattern is not necessarily removed in this step and may instead be removed after etching the first metal film 52.

In the case of wet etching the second metal film 54, an undercut may be generated to narrow the width of the first metal film to be etched later. At this time, if the photoresist pattern is not removed, baking may be performed on the photoresist pattern to prevent lifting of the photoresist pattern.

FIG. 19 shows the step of forming the gate electrode by etching the first metal film 52, in which the first metal film 52 is etched using the patterned second metal film 54 as a mask. Of course, in the case that the photoresist pattern is not removed in the previous step, the photoresist pattern can be used as a mask and the photoresist pattern is removed after etching the first metal film.

FIGS. 20 through 23 are sectional views for explaining a method of manufacturing a liquid crystal display according to a fourth embodiment of the present invention. Here, the initial steps through the step of forming the gate electrode are shown.

FIG. 20 shows the steps of forming conductive films 62 and 64 for the gate electrode and a photoresist pattern 66, which are identical to those of the second and the third embodiments.

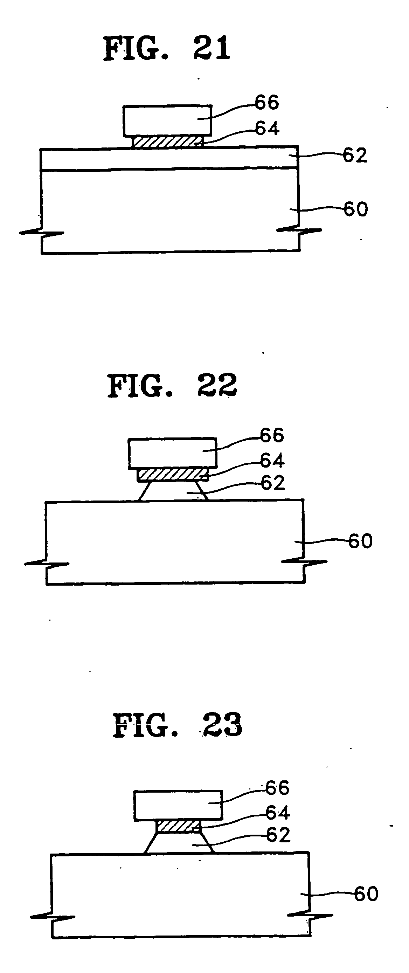

FIG. 21 shows the step of etching the second metal film, in which the second metal film 64 is wet etched using the photoresist pattern 66 as a mask. At this time, the second metal film is sufficiently etched so as to generate an undercut.

FIG. 22 shows the step of etching the first metal film, in which the undercut is formed in the gate electrode as shown in FIG. 12 when the first metal film 62 is wet etched using the patterned second metal film 64 as a mask.

FIG. 23 shows the step of re-etching the second metal film, in which the width of the lower portion of the first metal film 62 becomes wider than that of the second metal film 64 when the patterned second metal metal film 64 is re-etched, thus the undercut of the gate electrode is removed. Here, when etching the first metal film 62 or when re-etching the second metal film 64, baking may be performed on the second metal film 64 after performing the first etching on the second metal film 64, considering the case in which the lifting of the photoresist is generated.

According to the above-mentioned method for manufacturing the liquid crystal display according to the present invention, the gate electrode is formed in a two-layered-structure of Al or Al alloy and a refractory metal. Therefore, it is possible to prevent a battery effect caused by directly contacting the Al to the ITO layer and to prevent the generation of a hillock of the Al due to stress relaxation of the refractory metal. Also, it is possible to reduce the number of photolithography processes since it is possible to omit the anodizing process because of the refractory metal and to etch simultaneously the insulating film and the protection film.

Since it is possible to form the Al film or Al alloy film formed on the lower area so as to be either identical in size to or larger than the refractory metal formed on the upper portion, an undercut is not generated in the gate electrode. Therefore, it is possible to prevent the deterioration of insulation characteristics caused by poor step coverage.

The present invention is not restricted to the above embodiments, and it is clearly understood that many variations can be possible within the scope of the present invention as defined by the apended claims by anyone skilled in the art.

## Claims

1. A method of manufacturing a liquid crystal display, the method comprising the following sequence of steps :
(a) forming by a first photolithography process a gate electrode and a gate pad by deposition of a first metal film (22,42,52,62) and a second metal film (24,44,54,64) on a thin film transistor area and a pad area respectively of a substrate (20,40,50,60);
(b) forming an insulating film (26,46,56,66) on the entire surface of said substrate (20,40,50,60) on which said gate electrode and said gate pad are formed;
(c) forming by a second photolithography process a semiconductor film pattern (28,30) on said insulating film (26) on the thin film transistor area;
(d) forming by a third photolithography process a source electrode (32a) and a drain electrode (32b) composed of a third metal film in the thin film transistor area;
(e) forming a protection film (34) on the entire surface of said substrate (20) on which the source electrode (32a) and the drain electrode (32b) are formed; and patterning the protection film (34) at locations defined by a fourth photolithography process so as to expose a portion of said drain electrode (32b) and a portion of said gate pad on said substrate (20), wherein in the gate pad area the patterning includes etching the protection film (34) and the insulating film (26) in the same processing step ; and
(f) simultaneously forming by a fifth photolithography process a pixel electrode (36) connected to said drain electrode (32b) and a pixel electrode (36a) connected to said gate pad on said substrate (20) on which said protection film is formed.

2. The method of manufacturing a liquid crystal display as claimed in claim 1, wherein said step (c) comprises the steps of depositing an amorphous silicon film and a doped amorphous silicon film on said insulating film and patterning the amorphous silicon film and the doped amorphous silicon film.

3. The method of manufacturing a liquid crystal display according to claim 2, further comprising removing the doped amorphous silicon film between the source electrode (32a) and the drain electrode (32b).

4. The method of manufacturing a liquid crystal display as claimed in any preceding claim, wherein said first metal film is formed of Al or Al-alloy and said second metal film is formed of a refractory metal.

5. The method of manufacturing a liquid crystal display as claimed in any preceding claim, wherein said step (a) of forming said gate electrode includes the steps of:
(a1) forming said first metal film (42) and said second metal film (44) on a substrate (40) in the described order;
(a2) forming a photoresist pattern (46) on a portion of said second metal film (44);
(a3) etching said second metal film (44) using said photoresist pattern (46) as a mask;
(a4) reflowing said photoresist pattern (46);
(a5) etching said first metal film (42) using said reflowed photoresist pattern (46a) as a mask; and
(a6) removing said reflowed photoresist pattern (46a).

6. The method of manufacturing a liquid crystal display as claimed in claim 5, wherein said second metal film (44) is overetched in said step (a3) of etching said second metal film to generate an undercut.

7. The method of manufacturing a liquid crystal display as claimed in claim 5 or 6, wherein said step (a4) of reflowing said photoresist pattern is performed in a plurality of steps.

8. The method of manufacturing a liquid crystal display as claimed in any of claims 1 to 4, wherein said step (a) of forming said gate electrode includes the steps of:
(a1') forming said first metal film (52) and said second metal film (54) on said substrate (50) in the described order;
(a2') forming a photoresist pattern (56) on a portion of said second metal film (54);
(a3') etching said second metal film (54) by etching using said photoresist pattern (56) as a mask; and
(a4') etching said first metal film (52).

9. The method of manufacturing a liquid crystal display as claimed in claim 8, wherein said step (a3') of etching said second metal film (54) is performed by wet etching.

10. The method of manufacturing a liquid crystal display as claimed in claim 8, further comprising the step of baking said photoresist pattern (56) after said step (a3') which comprises dry etching said second metal film (54).

11. The method of manufacturing a liquid crystal display as claimed in any of claims 1 to 4, wherein said step of forming said gate electrode includes the steps of:
(a1") forming said first metal film (62) and said second metal film (64) on a substrate (60);
(a2'') forming a photoresist pattern (66) on a portion of said second metal film (64);
(a3'') etching said second metal film (64) using said photoresist pattern (66) as a mask;
(a4") etching said first metal film (62) using said patterned second metal film (64); and
(a5'') re-etching said patterned second metal film (64).

12. The method of manufacturing a liquid crystal display as claimed in claim 11, further comprising the step of baking said photoresist pattern prior to said step (a4'') of etching said first metal film after etching said second metal film.

13. The method of manufacturing a liquid crystal display as claimed in any preceding claim, wherein the pixel electrodes (36,36a) comprise indium tin oxide (ITO).

14. The method of manufacturing a liquid crystal display as claimed in any preceding claim, wherein the pixel electrode (36a) remains on the gate pad in the step of forming a pixel electrode.

15. The method of manufacturing a liquid crystal display as claimed in any preceding claim, wherein the second metal film comprises Cr, Ta, Mo or Ti.

16. The method of manufacturing a liquid crystal display as claimed in any one of claims 1 to 14, wherein the second metal film comprises a refractory metal.

17. The method of manufacturing a liquid crystal display as claimed in any preceding claim, wherein the third metal film comprises Cr.

## Patentansprüche

1. Verfahren zur Herstellung einer Flüssigkristallanzeige, wobei das Verfahren die folgende Abfolge von Schritten umfasst:
(a) durch einen ersten Photolithographieprozess Ausbilden einer Gateelektrode und eines Gatepads durch Abscheiden eines ersten Metallfilms (22, 42, 52, 62) und eines zweiten Metallfilms (24, 44, 54, 64) auf einem Dünnfilmtransistorbereich bzw. einem Padbereich eines Substrats (20, 40, 50, 60),
(b) Ausbilden eines Isolierfilms (26, 46, 56, 66) auf der gesamten Oberfläche des Substrats (20, 40, 50, 60), auf dem die Gateelektrode und das Gatepad ausgebildet sind,
(c) durch einen zweiten Photolithographieprozess Ausbilden eines Halbleiterfilmmusters (28, 30) auf dem Isolierfilm (26) auf dem Dünnfilmtransistorbereich,
(d) durch einen dritten Photolithographieprozess Ausbilden einer Sourceelektrode (32a) und einer Drainelektrode (32b) gebildet aus einem dritten Metallfilm im Dünnfilmtransistorbereich,
(e) Ausbilden eines Schutzfilms (34) auf der gesamten Oberfläche des Substrats (20), auf dem die Sourceelektrode (32a) und die Drainelektrode (32b) ausgebildet sind, und Mustern des Schutzfilms (34) an Stellen, die durch einen vierten Photolithographieprozess definiert sind, so dass ein Teil der Drainelektrode (32b) und ein Teil des Gatepad auf dem Substrat (20) freigelegt werden, worin im Gatepadbereich das Mustern Ätzen des Schutzfilms (34) und des Isolierfilms (26) im selben Bearbeitungsschritt beinhaltet; und
(f) durch einen fünften Photolithographieprozess gleichzeitiges Ausbilden einer Pixelelektrode (36), die mit der Drainelektrode (32b) verbunden ist, und einer Pixelelektrode (36a), die mit dem Gatepad verbunden ist, auf dem Substrat (20), auf dem der Schutzfilm ausgebildet ist.

2. Verfahren zur Herstellung einer Flüssigkristallanzeige nach Anspruch 1, worin Schritt (c) die Schritte zum Abscheiden eines amorphen Siliciumfilms und eines dotierten amorphen Siliciumfilms auf dem Isolierfilm und Mustern des amorphen Siliciumfilms und des dotierten amorphen Siliciumfilms umfasst.

3. Verfahren zur Herstellung einer Flüssigkristallanzeige nach Anspruch 2, ferner umfassend Entfernen des dotierten amorphen Siliciumfilms zwischen der Sourceelektrode (32a) und der Drainelektrode (32b).

4. Verfahren zur Herstellung einer Flüssigkristallanzeige nach einem der vorhergehenden Ansprüche, worin der erste Metallfilm aus Al oder Al-Legierung gebildet wird und der zweite Metallfilm aus einem hochschmelzenden Metall gebildet wird.

5. Verfahren zur Herstellung einer Flüssigkristallanzeige nach einem der vorhergehenden Ansprüche, worin der Schritt (a) zum Ausbilden der Gateelektrode die Schritte beinhaltet:
(a1) Ausbilden des ersten Metallfilms (42) und des zweiten Metallfilms (44) auf einem Substrat (40) in der beschriebenen Reihenfolge;
(a2) Ausbilden eines Photoresistmusters (46) auf einem Teil des zweiten Metallfilms (44);
(a3) Ätzen des zweiten Metallfilms (44) unter Verwendung des Photoresistmusters (46) als Maske;
(a4) Reflowbehandlung des Photoresistmusters (46);
(a5) Ätzen des ersten Metallfilms (42) unter Verwendung des Photoresistmusters nach Reflowbehandlung (46a) als Maske; und
(a6) Entfernen des Photoresistmusters nach Reflowbehandlung (46a).

6. Verfahren zur Herstellung einer Flüssigkristallanzeige nach Anspruch 5, worin der zweite Metallfilm (44) in Schritt (a3) zum Ätzen des zweiten Metallfilms überätzt wird, um einen Unterschnitt zu erzeugen.

7. Verfahren zur Herstellung einer Flüssigkristallanzeige nach Anspruch 5 oder 6, worin der Schritt (a4) zur Reflowbehandlung des Photoresistmusters in einer Mehrzahl von Schritten durchgeführt wird.

8. Verfahren zur Herstellung einer Flüssigkristallanzeige nach einem der Ansprüche 1 bis 4, worin der Schritt (a) zum Ausbilden der Gateelektrode die Schritte beinhaltet:
(a1') Ausbilden des ersten Metallfilms (52) und des zweiten Metallfilms (54) auf dem Substrat (50) in der beschriebenen Reihenfolge;
(a2') Ausbilden eines Photoresistmusters (56) auf einem Teil des zweiten Metallfilms (54);
(a3') Ätzen des zweiten Metallfilms (54) unter Verwendung des Photoresistmusters (56) als Maske; und
(a4') Ätzen des ersten Metallfilms (52).

9. Verfahren zur Herstellung einer Flüssigkristallanzeige nach Anspruch 8, worin Schritt (a3') zum Ätzen des zweiten Metallfilms (54) durch Nassätzen durchgeführt wird.

10. Verfahren zur Herstellung einer Flüssigkristallanzeige nach Anspruch 8, ferner umfassend den Schritt zum Brennen des Photoresistmusters (56) nach Schritt (a3'), der Trockenätzen des zweiten Metallfilms (54) umfasst.

11. Verfahren zur Herstellung einer Flüssigkristallanzeige nach einem der Ansprüche 1 bis 4, worin der Schritt zum Ausbilden der Gateelektrode die Schritte beinhaltet:
(a1") Ausbilden des ersten Metallfilms (62) und des zweiten Metallfilms (64) auf dem Substrat (60);
(a2") Ausbilden eines Photoresistmusters (66) auf einem Teil des zweiten Metallfilms (64);
(a3") Ätzen des zweiten Metallfilms (64) unter Verwendung des Photoresistmusters (66) als Maske;
(a4") Ätzen des ersten Metallfilms (62) unter Verwendung des gemusterten zweiten Metallfilms (64); und
(a5") erneutes Ätzen des gemusterten zweiten Metallfilms (64).

12. Verfahren zur Herstellung einer Flüssigkristallanzeige nach Anspruch 11, ferner umfassend den Schritt zum Brennen des Photoresistmusters vor dem Schritt (a4") zum Ätzen des ersten Metallfilms nach Ätzen des zweiten Metallfilms.

13. Verfahren zur Herstellung einer Flüssigkristallanzeige nach einem der vorhergehenden Ansprüche, worin die Pixelelektroden (36, 36a) Indiumzinnoxid (ITO) umfassen.

14. Verfahren zur Herstellung einer Flüssigkristallanzeige nach einem der vorhergehenden Ansprüche, worin im Schritt zum Ausbilden einer Pixelelektrode die Pixelelektrode (36) auf dem Gatepad verbleibt.

15. Verfahren zur Herstellung einer Flüssigkristallanzeige nach einem der vorhergehenden Ansprüche, worin der zweite Metallfilm Cr, Ta, Mo oder Ti umfasst.

16. Verfahren zur Herstellung einer Flüssigkristallanzeige nach einem der Ansprüche 1 bis 14, worin der zweite Metallfilm ein hochschmelzendes Metall umfasst.

17. Verfahren zur Herstellung einer Flüssigkristallanzeige nach einem der vorhergehenden Ansprüche, worin der dritte Metallfilm Cr umfasst.

## Revendications

1. Procédé de fabrication d'un afficheur à cristaux liquides, le procédé comprenant la séquence suivante d'étapes consistant à :
(a) former par un premier processus de photolithographie une électrode de grille et une pastille de grille par dépôt d'un premier film métallique (22, 42, 52, 62) et d'un deuxième film métallique (24, 44, 54, 64) sur une zone de transistors à couches minces et une zone de pastille respectivement d'un substrat (20, 40, 50, 60) ;
(b) former un film isolant (26, 46, 56, 66) sur toute la surface dudit substrat (20, 40, 50, 60) sur lequel ladite électrode de grille et ladite pastille de grille sont formées ;
(c) former par un deuxième processus de photolithographie un motif de film semi-conducteur (28, 30) sur ledit film isolant (26) sur la zone de transistors à couches minces ;
(d) former par un troisième processus de photolithographie une électrode source (32a) et une électrode de drain (32b) composées d'un troisième film métallique dans la zone de transistors à couches minces ;
(e) former un film de protection (34) sur toute la surface dudit substrat (20) sur lequel l'électrode source (32a) et l'électrode de drain (32b) sont formées ; et former les motifs du film de protection (34) à des emplacements définis par un quatrième processus de photolithographie afin d'exposer une partie de ladite électrode de drain (32b) et une partie de ladite pastille de grille sur ledit substrat (20), dans lequel, dans la zone de pastille de grille, la formation des motifs inclut la gravure du film de protection (34) et du film isolant (26) dans la même étape de traitement ; et
(f) former simultanément par un cinquième processus de photolithographie une électrode pixel (36) reliée à ladite électrode de drain (32b) et une électrode pixel (36a) reliée à ladite pastille de grille sur ledit substrat (20) sur lequel ledit film de protection est formé.

2. Procédé de fabrication d'un afficheur à cristaux liquides selon la revendication 1, dans lequel ladite étape (c) comprend les étapes consistant à déposer un film de silicium amorphe et un film de silicium amorphe dopé sur ledit film isolant et à former les motifs sur le film de silicium amorphe et le film de silicium amorphe dopé.

3. Procédé de fabrication d'un afficheur à cristaux liquides selon la revendication 2, comprenant en outre le retrait du film de silicium amorphe dopé entre l'électrode source (32a) et l'électrode de drain (32b).

4. Procédé de fabrication d'un afficheur à cristaux liquides selon l'une quelconque des revendications précédentes, dans lequel ledit premier film métallique est formé de Al ou d'un alliage de Al et ledit deuxième film métallique est formé d'un métal réfractaire.

5. Procédé de fabrication d'un afficheur à cristaux liquides selon l'une quelconque des revendications précédentes, dans lequel ladite étape (a) de formation de ladite électrode de grille comprend les étapes consistant à :
(a1) former ledit premier film métallique (42) et ledit deuxième film métallique (44) sur un substrat (40) dans l'ordre décrit ;
(a2) former un motif de résine photosensible (46) sur une partie dudit deuxième film métallique (44) ;
(a3) graver ledit deuxième film métallique (44) en utilisant ledit motif de résine photosensible (46) comme masque ;
(a4) refusionner ledit motif de résine photosensible (46) ;
(a5) graver ledit premier film métallique (42) en utilisant ledit motif de résine photosensible refusionné (46a) comme masque ; et
(a6) retirer ledit motif de résine photosensible refusionné (46a).

6. Procédé de fabrication d'un afficheur à cristaux liquides selon la revendication 5, dans lequel ledit deuxième film métallique (44) est surgravé pendant ladite étape (a3) de gravure dudit deuxième film métallique pour générer une sous gravure.

7. Procédé de fabrication d'un afficheur à cristaux liquides selon la revendication 5 ou 6, dans lequel ladite étape (a4) de refusion dudit motif de résine photosensible est réalisée selon une pluralité d'étapes.

8. Procédé de fabrication d'un afficheur à cristaux liquides selon l'une quelconque des revendications 1 à 4, dans lequel ladite étape (a) de formation de ladite électrode de grille comprend les étapes consistant à :
(a1') former ledit premier film métallique (52) et ledit deuxième film métallique (54) sur ledit substrat (50) dans l'ordre décrit ;
(a2') former un motif de résine photosensible (56) sur une partie dudit deuxième film métallique (54) ;
(a3') graver ledit deuxième film métallique (54) par une gravure utilisant ledit motif de résine photosensible (56) comme masque ; et
(a4') graver ledit premier film métallique (52).

9. Procédé de fabrication d'un afficheur à cristaux liquides selon la revendication 8, dans lequel ladite étape (a3') de gravure dudit deuxième film métallique (54) est réalisée par gravure humide.

10. Procédé de fabrication d'un afficheur à cristaux liquides selon la revendication 8, comprenant en outre l'étape consistant à cuire ledit motif de résine photosensible (56) après ladite étape (a3') qui comprend la gravure sèche dudit deuxième film métallique (54).

11. Procédé de fabrication d'un afficheur à cristaux liquides selon l'une quelconque des revendications 1 à 4, dans lequel ladite étape de formation de ladite électrode de grille comprend les étapes consistant à :
(a1") former ledit premier film métallique (62) et ledit deuxième film métallique (64) sur un substrat (60) ;
(a2") former un motif de résine photosensible (66) sur une partie dudit deuxième film métallique (64) ;
(a3") graver ledit deuxième film métallique (64) en utilisant ledit motif de résine photosensible (66) comme masque ;
(a4'') graver ledit premier film métallique (62) en utilisant ledit deuxième film métallique à motif (64) ; et
(a5'') regraver ledit deuxième film métallique à motif (64).

12. Procédé de fabrication d'un afficheur à cristaux liquides selon la revendication 11, comprenant en outre l'étape consistant à cuire ledit motif de résine photosensible avant ladite étape (a4") de gravure dudit premier film métallique après la gravure dudit deuxième film métallique.

13. Procédé de fabrication d'un afficheur à cristaux liquides selon l'une quelconque des revendications précédentes, dans lequel les électrodes pixel (36, 36a) comprennent de l'oxyde d'indium et d'étain (en anglais « Indium Tin Oxide » - ITO).

14. Procédé de fabrication d'un afficheur à cristaux liquides selon l'une quelconque des revendications précédentes, dans lequel l'électrode pixel (36a) reste sur la pastille de grille à l'étape de formation d'une électrode pixel.

15. Procédé de fabrication d'un afficheur à cristaux liquides selon l'une quelconque des revendications précédentes, dans lequel le deuxième film métallique comprend du Cr, Ta, Mo ou Ti.

16. Procédé de fabrication d'un afficheur à cristaux liquides selon l'une quelconque des revendications 1 à 14, dans lequel le deuxième film métallique comprend un métal réfractaire.

17. Procédé de fabrication d'un afficheur à cristaux liquides selon l'une quelconque des revendications précédentes, dans lequel le troisième film métallique comprend du Cr.
